# EUROPEAN PATENT SPECIFICATION

(11) **EP 4 284 960 B1**
(45) Date of publication and mention of the grant of the patent: **28.10.2026**
(21) Application number: 22763894.7
(22) Date of filing: 01.03.2022
(51) Int. Cl.: C23C 16/455, C23C 16/40, C23C 16/38

(54) **COMPOSITIONS AND METHODS USING SAME FOR FILMS COMPRISING SILICON AND BORON**
ZUSAMMENSETZUNGEN UND VERFAHREN DAMIT FÜR FILME MIT SILICIUM UND BOR
COMPOSITIONS ET PROCÉDÉS LES UTILISANT POUR FILMS COMPRENANT DU SILICIUM ET DU BORE

(30) Priority: 02.03.2021 US 202163155567 P
(43) Date of publication of application: 06.12.2023
(73) Proprietor: Versum Materials US, LLC, Tempe, AZ 85284 (US); Samsung Electronics Co., Ltd., Gyeonggi-Do, 445-701 (KR)
(72) Inventor: CHANDRA, Haripin, Tempe, Arizona 85284 (US); LI, Ming, Tempe, Arizona 85284 (US); XIAO, Manchao, Tempe, Arizona 85284 (US); LEI, Xinjian, Tempe, Arizona 85284 (US); KIM, Hyunwoo, Hwasung-City Gyunggi-Do, 445-701 (KR); HWANG, Byung Keun, Hwasung-City Gyunggi-Do, 445-701 (US); HWANG, Sunhye, Hwasung-City Gyunggi-Do, 445-701 (US); CHO, Younjoung, Hwasung-City Gyunggi-Do, 445-701 (KR)
(74) Representative: Sommer, Andrea
(86) International application number: PCT/US2022/018330
(87) International publication number: WO 2022/187238

(56) References cited:
- WO-A1-02/22625
- WO-A1-2020/068770
- DE-A1- 102006 013 469
- KR-B1- 102 135 799
- US-A1- 2008 063 791
- US-A1- 2012 032 311
- US-A1- 2012 214 318
- US-A1- 2020 365 401
- SEHLLEIER YEE HWA ET AL: "Solid-State NMR Investigations on the Amorphous Network of Precursor-Derived Si 2 B 2 N 5 C 4 Ceramics", ZEITSCHRIFT FUR ANORGANISCHE UND ALLGEMEINE CHEMIE, vol. 638, no. 11, 24 August 2012 (2012-08-24), Hoboken, USA, pages 1804 - 1809, XP093195328, ISSN: 0044-2313, DOI: 10.1002/zaac.201200332
- JÄSCHKE THOMAS ET AL: "Synthesis and characterization of new amorphous Si/B/N/C ceramics with increased carbon content through single-source precursors", COMPTES RENDUS. CHIMIE, vol. 7, no. 5, 1 May 2004 (2004-05-01), pages 471 - 482, XP093195335, ISSN: 1878-1543, DOI: 10.1016/j.crci.2004.01.005

## Description

### FIELD OF THE INVENTION

Described herein is a composition and method for the fabrication of an electronic device. More specifically, described herein are compounds, and compositions and methods comprising the same, for the deposition of a low dielectric constant (< 6.0) and high oxygen ash resistance films comprising silicon and boron such as, without limitation, a silicon borocarboxide, a silicon borocarbonitride, a silicon boroxide, and a silicon borocarboxynitride via atomic layer deposition.

### BACKGROUND OF THE INVENTION

There is a need in the art to provide a composition and method using same for depositing a film comprising silicon and boron with high boron content (e.g., a boron content of about 10 atomic % or greater as measured by X-ray photoelectron spectroscopy (XPS) for certain applications within the electronics industry.

US6093840 discloses silylalkylboranes having general formula I R¹R²R³SiC(R⁴)C(R^{S}R⁶H)BR⁷R⁸ wherein R¹⁻³ = C1-6-alkyl, vinyl, Ph, H, or halogen; R⁴⁻⁶ = C1-6-alkyl, vinyl, Ph, and/or H; R⁷, R⁸ = chloride and/or bromide), each Si atom and each B atom is coordinated with 3 and 2 R moieties, respectfully, and the Si and B are connected via a C(CR⁵R⁶H)(R⁴) bridge. The silicoborocarbonitride ceramics are manufactured by pyrolyzing ≥1 oligo- and polyborocarbosilazanes in NH₃ or inert gas atm. at -200 to 2000°C, and calcining the material at 800-2000°C.

US 6815350 and US6962876 disclose a method for forming a low-k dielectric layer for a semiconductor device using an ALD process including (a) forming predetermined interconnection patterns on a semiconductor substrate, (b) supplying a 1st and a 2nd reactive material to a chamber having the substrate therein, thereby adsorbing the 1st and 2nd reactive materials on a surface of the substrate, (c) supplying a 1st gas to the chamber to purge the 1st and 2nd reactive materials that remain unreacted, (d) supplying a 3rd reactive material to the chamber, thereby causing a reaction between the 1st and 2nd materials and the 3rd reactive material to form a monolayer, (e) supplying a 2nd gas to the chamber to purge the 3rd reactive material that remains unreacted in the chamber and a byproduct; and (f) repeating (b) through (e) a predetermined no. of times to form a SiBN ternary layer having a predetermined thickness on the substrate.

US9293557 B and US9590054 B disclose semiconductor structures and methods for making the same that include a boron nitride (BN) spacer on a gate stack, such as a gate stack of a planar FET or FinFET. The boron nitride spacer is fabricated using at. layer deposition (ALD) and/or plasma enhanced at. layer deposition (PEALD) techniques to produce a boron nitride spacer at relatively low temps. that are conducive to devices made from materials such as silicon (Si), silicon germanium (SiGe), germanium (Ge), and/or III-V compounds. Furthermore, the boron nitride spacer may be fabricated to have various desirable properties, including a hexagonal textured structure.

US9520282 discloses a method of manufacturing a semiconductor device, includes treating a surface of an insulating film formed on a substrate by supplying a first precursor including a predetermined element and a halogen group to the substrate; and forming a thin film including the predetermined element on the treated surface of the insulating film by performing a cycle a predetermined no. of times, the cycle comprising: supplying a second precursor including the predetermined element and the halogen group to the substrate; and supplying a third precursor to the substrate.

US 20140170858 A discloses a method including forming a film including a predetermined element, oxygen and at least one element selected from a group consisting of nitrogen, carbon and boron on a substrate by performing a cycle a predetermined no. of times, the cycle including supplying a source gas to the substrate wherein the source gas contains the predetermined element, chlorine and oxygen with a chem. bond of the predetermined element and oxygen, and supplying a reactive gas to the substrate wherein the reactive gas contains the at least one element selected from the group consisting of nitrogen, carbon and boron.

US2013052836A discloses a method for manufacturing a semiconductor device, including forming an insulating film having a prescribed composition and a prescribed film thickness on a substrate by alternately performing the following steps prescribed number of times: supplying one of the sources of a chlorosilane-based source and an aminosilane-based source to a substrate in a processing chamber, and thereafter supplying the other source, to form a first layer containing silicon, nitrogen, and carbon on the substrate; and supplying a reactive gas different from each of the sources, to the substrate in the processing chamber, to modify the first layer and form a second layer. ;

US 20140273507A discloses a method of manufacturing a semiconductor device is disclosed. The method includes forming a thin film having a borazine ring skeleton and containing a predetermined element, boron, carbon, and nitrogen on a substrate by performing a cycle a predetermined no. of times. The cycle includes supplying a precursor gas containing the predetermined element and a halogen element to the substrate; supplying a reaction gas including an organic borazine compound to the substrate; and supplying a carbon-containing gas to the substrate. The cycle was performed under a condition in which the borazine ring skeleton in the organic borazine compd. is maintained.

R. Southwick et al (2015). A Novel ALD SiBCN Low-k Spacer for Parasitic Capacitance Reduction in FinFETs, 2015 Symposium on VLSI Technology. Kyoto Japan discloses a novel low temperature ALD-based SiBCN material has been identified, with an optimized spacer RIE process developed to preserve the low-k value and provide compatibility with the down-stream processes. The material has been integrated into a manufacturable 14nm replacement-metal-gate (RMG) FinFET baseline with a demonstrated ~8% performance improvement in the RO delay with reliability meeting the technology requirement. A guideline for spacer design consideration for 10nm node and beyond is also provided based on the comprehensive material properties and reliability evaluations.

US9472391 B discloses a semiconductor device manufacturing method includes forming a thin film containing silicon, oxygen, carbon and a specified Group III or Group V element on a substrate by performing a cycle a predetermined no. of times. The cycle includes: supplying a precursor gas Including silicon, carbon and a halogen element and having an Si-C bonding and a first catalytic gas to the substrate; supplying an oxidizing gas and a second catalytic gas to the substrate; and supplying a modifying gas including the specified Group III or Group V element to the substrate.

Yang, S. R., et al. (2006) Low k SiBN (Silicon Boron Nitride) Film Synthesized by a Plasma-Assisted Atomic Layer Deposition. ECS Transactions, 1, 79 describes SiBN films were prepared by plasma assisted atomic layer deposition (PAALD) using dichlorosilane, boron trichloride and ammonia as source gases. In this material system, the reaction control of boron, silicon and nitrogen is a key issue because nitrogen reacts more readily with boron than with silicon. On the other hand, ammonia radicals created by remote plasma during PAALD enhance the reaction between silicon and nitrogen. Therefore, PAALD enables an enhanced controllability of silicon and boron contents. SiBN films with dielectric constant of 4.45 to 5.47 were applied to buried- contact (BC) spacer instead of SiN films in 70 nm DRAM device, and 12 - 24% reduction of bit-line loading capacitance (CBL) was obtained. Low-k SiBN films deposited using PAALD are promising materials for insulating interlayer such as Si3N4 spacer for future sub-70 nm DRAM devices.

DE 10 2006 013 469 A1 discloses siliciumcarbonitrid ceramics and methods for their preparation. As precursors for the preparation trichlorosilyl)(dichloroboryl)methane, 1-(trichlorosilyl)-1-(dichloroboryl)ethane, and (dichloromethylsilyl)(dichloroboryl)methane are disclosed and composition comprising these and organic solvents are disclosed. WO 2020/068770 discloses a method for forming a silicon nitride or carbon-doped silicon nitride via a plasma enhanced ALD process. In the process precursors of the formula R₃₋ₙXₙSi-R¹-SiXₘR²₃₋ₘ are used, wherein R¹ is an ethylene or propylene group, X is Cl or Br and hydrogen or lower alkyl.

US2008063791 discloses ALD of boron doped silicon carbon nitride films.

### BRIEF SUMMARY OF THE INVENTION

The composition and method of the present invention are as disclosed in the appended claims. The composition and method described herein overcome the problems of the prior art by providing a composition or formulation for depositing a conformal film comprising silicon and boron having one or more of the following properties; i) a dielectric constant of 6 or less and wet etch rate in dilute HF (dHF) less sensitive to damage during an oxygen ashing process or exposure to oxygen plasma, oxygen ash resistance being quantifiable as a damage thickness after O₂ ashing of < 50 Å measured by dHF dip, as well as a film dielectric constant after O₂ ash lower than 4.0; ii) a dielectric constant less than 6.0, preferably less than 5, most preferably less than 4; and (iv) a chlorine impurity in the resulting films less than 2.0 at. %, preferably less than 1.0 at. %, most preferably less than 0.5 at.%. The desirable properties that can be achieved by the instant invention are illustrated in greater detail in the Examples below.

In one particular embodiment, the composition described herein may be used in a method to deposit a film comprising silicon and boron using atomic layer deposition (ALD) employing precursors having one Si-C-B linkage listed in Table 1.

**Table 1 Precursors having one Si-C-B linkage**

| | |
|---|---|
| 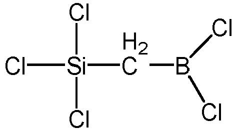 (trichlorosilyl)(dichloroboryl)methane | 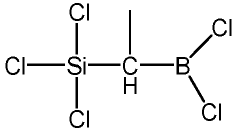 1-(trichlorosilyl)-1-(dichloroboryl)ethane |
| 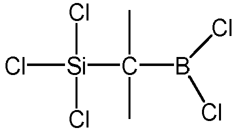 2-(trichlorosilyl)-2-(dichloroboryl)propane | 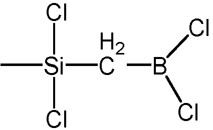 (dichloromethylsilyl)(dichloroboryl)methane |

In one aspect, the composition for depositing a film comprising silicon and boron comprises: (a) at least one precursor is 2-(trichlorosilyl)-2-(dichloroboryl)propane and (b) at least one solvent. In certain embodiments of the composition described herein, exemplary solvents can include, without limitation, ether, tertiary amine, alkyl hydrocarbon, aromatic hydrocarbon, siloxanes, tertiary aminoether, and combinations thereof. In certain embodiments, the difference between the boiling point of the silicon compounds and the boiling point of the solvent is 40°C or less, less than about 30°C and in some cases less than about 20°C, preferably less than 10°C.

In another aspect, there is provided a method for depositing a film comprising silicon and boron in appended claim 6.

In certain embodiments, the film comprising silicon and boron has a boron content of about 10 atomic weight percent (at. %) or greater as measured by XPS; carbon content of about 5 atomic weight percent (at. %) or greater as measured by XPS; and an etch rate of at least 0.5 times less than thermal silicon oxide as measured in dilute hydrofluoric acid. In some embodiments, the film comprising silicon and boron is a silicon borocarbonitride. In other embodiments, the film comprising silicon and boron is a silicon borocarbonitride, or a silicon borocarboxynitride.

If desired, the invention further comprises treating the film comprising silicon and boron with hydrogen plasma or hydrogen/inert plasma at 25°C to 700°C to densify the resulting film as well as to reduce the dielectric constant.

A film can be formed according to any of the inventive methods. The film may comprise silicon and boron with a k of about 6 or less, preferably about 5 or less, and most preferably about 4 or less; a boron content of at least about 10 at. The film may comprise silicon and boron with a k of about 6 or less, preferably about 5 or less, and most preferably about 4 or less; a boron content of at least about 10 at. %, preferably at least about 15 at. %, and most preferably at least about 20 at. % based on XPS measurement. Since the carbon content is an important factor for reducing the wet etch rate as well as increasing the ash resistance, the carbon content for this invention ranges from 5 at. % to 30 at. %, preferably 10 at. % to 30 at. %, and most preferably 20 at. % to 30 at. % as measured by XPS.

Another aspect of the invention relates to stainless steel container housing the inventive compositions.

The embodiments of the invention may be used alone or in various combinations with each other.

### DETAILED DESCRIPTION OF THE INVENTION

Described herein is a precursor compound (not claimed), and compositions and methods comprising same, to deposit a carbon doped film comprising silicon and boron (e.g., having a boron content of about 10 at. % or greater as measured by XPS) via a deposition process such as, without limitation, a thermal atomic layer deposition process. The film deposited using the composition and method described herein exhibits an extremely low etch rate such as an etch rate no greater than 0.5 times the etch rate of thermal silicon oxide as measured in dilute hydrofluoric acid (e.g., about 0.20 Å/s or less or about 0.15 Å/s or less in dilute HF (0.5 wt. %), or no greater than 0.1 times the etch rate of thermal silicon oxide, or no greater than 0.05 times the etch rate of thermal silicon oxide, or no greater than 0.01 times the etch rate of thermal silicon oxide, while exhibiting variability in other tunable properties such as, without limitation, density, dielectric constant, refractive index, and elemental composition.

In certain embodiments, the precursors described herein, and methods using same, impart one or more of the following features in the following manner. First, the as-deposited, reactive carbon-doped silicon nitride film is formed using the precursors comprising a Si-C-B linkage, and a nitrogen source. Without wishing to be bound by any theory or explanation, it is believed that the Si-C-B linkage from the precursor remains in the resulting as-deposited film and provides a high boron content of at least 10 at. % or greater as measured by XPS (e.g., about 20 to about 40 at. % and in some cases about 15 to about 40 at. % boron). Second, when exposing the as-deposited film to an oxygen source, such as water, either intermittently during the deposition process, as a post-deposition treatment, or a combination thereof, at least a portion or all of the nitrogen content in the film is converted to oxygen to provide a film selected from a silicon borocarboxide, or a silicon borocarboxynitride film. The nitrogen in the as-deposited film is released as one or more nitrogen-containing by-products such as ammonia or an amine group.

In one aspect, the composition for depositing a film comprising silicon and boron comprises: (a) at least one precursor compound having one Si-C-B linkage which is 2-(trichlorosilyl)-2-(dichloroboryl)propane; and (b) at least one solvent. In certain embodiments of the composition described herein, exemplary solvents can include, without limitation, ether, tertiary amine, alkyl hydrocarbon, aromatic hydrocarbon, tertiary aminoether, siloxanes, and combinations thereof. In certain embodiments, the difference between the boiling point of the compound having one Si-C-B linkage and the boiling point of the solvent is 40°C or less. The wt. % of precursor compound in the solvent can vary from 1 to 99 wt. %, or 10 to 90 wt. %, or 20 to 80 wt. %, or 30 to 70 wt. %, or 40 to 60 wt. %, or 50 wt. %. In some embodiments, the composition can be delivered via direct liquid injection into a reactor chamber for the film comprising silicon and boron using conventional direct liquid injection equipment and methods.

In one embodiment, the substrate includes at least one feature wherein the feature comprises a pattern trench with aspect ratio of 1:9, opening of 180 nm. In some embodiments, the film comprising silicon and boron is a silicon borocarbonitride. In other embodiments, the film comprising silicon and boron is a silicon borocarbonitride and/or a silicon borocarboxynitride.

In yet another further embodiment of the method described herein, the film comprising silicon and boron is deposited using a thermal ALD process with a catalyst comprising an ammonia or organic amine. In this embodiment, the method comprises:
a. placing one or more substrates comprising a surface feature into an ALD reactor;
b. heating the reactor to one or more temperatures ranging from ambient temperature to about 150°C or lower and optionally maintaining the reactor at a pressure of 100 torr or less;
c. introducing into the reactor at least one precursor having one Si-C-B linkage selected from the group consisting of (trichlorosilyl)(dichloroboryl)methane, 1-(trichlorosilyl)-1-(dichloroboryl)ethane, 2-(trichlorosilyl)-2-(dichloroboryl)propane, and (dichloromethylsilyl)(dichloroboryl)methane, and optionally a catalyst;
d. purging the reactor with an inert gas
e. providing an oxygen source into the reactor to react with the precursor as well as a catalyst to form a film comprising silicon and boron;
f. purging the reactor with inert gas to remove any reaction by-products;
g. repeating steps c to f to provide a desired thickness of film comprising silicon and boron;
h. optionally providing a post-deposition treatment exposing the processed film comprising silicon and boron to a plasma comprising hydrogen to improve at least one of the films' properties;
i. optionally post-deposition treating the film comprising silicon and boron with a spike anneal at temperatures ranging from 400 to 1000°C or a UV light source. In this or other embodiments, the UV exposure step can be carried out either during film deposition, or once deposition has been completed.

In this or other embodiments, the catalyst is selected from a Lewis base such as pyridine, piperazine, ammonia, triethylamine or other organic amines. The amount of Lewis base vapors is at least one equivalent to the amount of the precursor vapors during step c. The oxygen source is vapors comprising water. In some embodiments, the film comprising silicon and boron is a silicon borocarboxide. In other embodiments, the film comprising silicon and boron is a silicon boroxide as the oxygen source may remove all carbon from the as-deposited film comprising silicon and boron during post-deposition treatment.

In certain embodiments, the resulting film comprising silicon and boron is exposed to organoaminosilanes or chlorosilanes having Si-Me or Si-H or both to form a hydrophobic thin layer before exposing to hydrogen plasma treatment. Suitable organoaminosilanes include, but not limited to, diethylaminotrimethylsilane, dimethylaminotrimethylsilane, ethylmethylaminotrimethylsilane, t-butylaminotrimethylsilane, iso-propylaminotrimethylsilane, di-isopropylaminotrimethylsilane, pyrrolidinotrimethylsilane, diethylaminodimethylsilane, dimethylaminodimethylsilane, ethylmethylaminodimethylsilane, t-butylaminodimethylsilane, iso-propylaminodimethylsilane, di-isopropylaminodimethylsilane, pyrrolidinodimethylsilane, bis(diethylamino)dimethylsilane, bis(dimethylamino)dimethylsilane, bis(ethylmethylamino)dimethylsilane, bis(di-isopropyllamino)dimethylsilane, bis(iso-propylamino)dimethylsilane, bis(tert-butylamino)dimethylsilane, dipyrrolidinodimethylsilane, bis(diethylamino)diethylsilane, bis(diethylamino)methylvinylsilane, bis(dimethylamino)methylvinylsilane bis(ethylmethylamino)methylvinylsilane, bis(di-isopropyllamino)methylvinylsilane, bis(iso-propylamino)methylvinylsilane, bis(tert-butylamino)methylvinylsilane, dipyrrolidinomethylvinylsilane, 2,6-dimethylpiperidinomethylsilane, 2,6-dimethylpiperidinodimethylsilane, 2,6-dimethylpiperidinotrimethylsilane, tris(dimethylamino)phenylsilane, tris(dimethylamino)methylsilane, di-iso-propylaminosilane, di-sec-butylaminosilane, chlorodimethylsilane, chlorotrimethylsilane, dichloromethylsilane, and dichlorodimethylsilane.

In another embodiments, the resulting film comprising silicon and boron is exposed to alkoxysilanes or cyclic alkoxysilanes having Si-Me or Si-H or both to form a hydrophobic thin layer before exposing to hydrogen plasma treatment. Suitable alkoxysilanes or cyclic alkoxysilanes include, but not limited to, diethoxymethylsilane, dimethoxymethylsilane, diethoxydmethylsilane, dimethoxydmethylsilane, 2,4,6,8-tetramethylcyclotetrasiloxane, or octamethylcyclotetrasiloxane. Without wishing to be bound by any theory or explanation, it is believed that the thin layer formed by the organoaminosilanes or alkoxysilanes or cyclic alkoxysilanes may convert into dense carbon doped silicon oxide during plasma ashing process, further boosting the ashing resistance.

In another embodiment, a vessel for depositing a film comprising silicon and boron contains one or more precursor compounds described herein. In one particular embodiment, the vessel comprises at least one pressurizable vessel (preferably of stainless steel having a design such as disclosed in U.S. Patent Nos. US7334595; US6077356; US5069244; and US5465766. The container can comprise either glass (borosilicate or quartz glass) or type 316, 316L, 304 or 304L stainless steel alloys (UNS designation S31600, S31603, S30400 S30403) fitted with the proper valves and fittings to allow the delivery of one or more precursors to the reactor for a CVD or an ALD process. In this or other embodiments, the precursor is provided in a pressurizable vessel comprised of stainless steel and the purity of the precursor is 98.0% by weight or greater or 99.0% or greater, or 99.5% or greater which is suitable for the semiconductor applications. The precursor compounds are preferably substantially free of metal ions such as, Al³⁺, Li¹⁺ , Ca²⁺, Fe²⁺, Fe³⁺, Ni²⁺, Cr³⁺. As used herein, the term "substantially free" as it relates to Al, Li, Ca, Fe, Ni, Cr means less than about 5 ppm (by weight), preferably less than about 3 ppm, and more preferably less than about 1 ppm, and most preferably about 0.1 ppm as measured by ICP-MS. In certain embodiments, such vessels can also have means for mixing the precursors with one or more additional precursor if desired. In these or other embodiments, the contents of the vessel(s) can be premixed with an additional precursor. Alternatively, the precursor is and/or other precursor can be maintained in separate vessels or in a single vessel having separation means for maintaining the precursor is and other precursor separate during storage.

The film comprising silicon and boron is deposited upon at least a surface of a substrate such as a semiconductor substrate. In the method described herein, the substrate may be comprised of and/or coated with a variety of materials well known in the art including films of silicon such as crystalline silicon or amorphous silicon, silicon oxide, silicon nitride, amorphous carbon, silicon oxycarbide, silicon oxynitride, silicon carbide, germanium, germanium doped silicon, boron doped silicon, metal such as copper, tungsten, aluminum, cobalt, nickel, tantalum), metal nitride such as titanium nitride, tantalum nitride, metal oxide, group III/V metals or metalloids such as GaAs, InP, GaP and GaN, and a combination thereof. These coatings may completely coat the semiconductor substrate, may be in multiple layers of various materials and may be partially etched to expose underlying layers of material. The surface may also have on it a photoresist material that has been exposed with a pattern and developed to partially coat the substrate. In certain embodiments, the semiconductor substrate comprising at least one surface feature selected from the group consisting of pores, vias, trenches, and combinations thereof. The potential application of the silicon- and boron-containing films include but not limited to low k spacer for FinFET or nanosheet, sacrificial hard mask for self aligned patterning process (such as SADP, SAQP, or SAOP).

The deposition method used to form the film comprising silicon and boron or coatings are deposition processes. The suitable deposition processes for the method disclosed herein is an atomic layer deposition process. As used herein, the term "chemical vapor deposition process" refers to any process wherein a substrate is exposed to one or more volatile precursors, which react and/or decompose on the substrate surface to produce the desired deposition. As used herein, the term "atomic layer deposition process" refers to a self-limiting (e.g., the amount of film material deposited in each reaction cycle is constant), sequential surface chemistry that deposits films of materials onto substrates of varying compositions. As used herein, the term "thermal atomic layer deposition process" refers to atomic layer deposition process at substrate temperatures ranging from room temperature to 700°C, or 100 to 650°C, or 200 to 650°C, or 300 to 600°C without in situ or remote plasma. In other embodiments, the precursors described herein can be used, for example, in low temperature deposition when a catalyst is employed at temperatures ranging from about 20°C to about 150°C, or about 50°C to about 150°C. Although the precursors, reagents and sources used herein may be sometimes described as "gaseous", it is understood that the precursors can be either liquid or solid which are transported with or without an inert gas into the reactor via direct vaporization, bubbling or sublimation. In some case, the vaporized precursors can pass through a plasma generator.

The film comprising silicon and boron is deposited using an ALD process. In a further embodiment, the film comprising silicon and boron is deposited using a thermal ALD process. The term "reactor" as used herein, includes without limitation, reaction chamber or deposition chamber.

In certain embodiments, the method disclosed herein avoids pre-reaction of precursor(s) by using ALD methods that separate the precursor(s) prior to and/or during the introduction to the reactor. ALD processes are used to deposit the silicon- and boron-containing film. In one embodiment, the film is deposited via an ALD process in a typical single wafer ALD reactor, semi-batch ALD reactor, or batch furnace ALD reactor by exposing the substrate surface alternatively to the one or more the silicon- and boron-containing precursor, oxygen source, nitrogen-containing source, or other precursor or reagent. Film growth proceeds by self-limiting control of surface reaction, the pulse length of each precursor or reagent, and the deposition temperature. However, once the surface of the substrate is saturated, the film growth ceases. In another embodiment, each reactant including the precursor and reactive gas is exposed to a substrate by moving or rotating the substrate to different sections of the reactor and each section is separated by inert gas curtain, i.e. spatial ALD reactor or roll to roll ALD reactor.

Depending upon the deposition method, in certain embodiments, the silicon precursors described herein and optionally other silicon- and boron-containing precursors may be introduced into the reactor at a predetermined molar volume, or from about 0.1 to about 1000 micromoles. In this or other embodiments, the precursor may be introduced into the reactor for a predetermined time period. In certain embodiments, the time period ranges from about 0.001 to about 500 seconds.

In certain embodiments, the film comprising silicon and boron deposited using the methods described herein are formed in the presence of a catalyst in combination with an oxygen source, reagent or precursor comprising oxygen, i.e. water vapors. An oxygen source may be introduced into the reactor in the form of at least one oxygen source and/or may be present incidentally in the other precursors used in the deposition process. Suitable oxygen source gases may include, for example, water (H₂O) (e.g., deionized water, purified water, distilled water, water vapor, water vapor plasma, oxygenated water, air, a composition comprising water and other organic liquid), oxygen (O₂), oxygen plasma, ozone (O₃), nitric oxide (NO), nitrogen dioxide (NO₂), carbon monoxide (CO), a plasma comprising water, a plasma comprising water and argon, hydrogen peroxide, a composition comprising hydrogen, a composition comprising hydrogen and oxygen, carbon dioxide (CO₂), air, and combinations thereof. In certain embodiments, the oxygen source comprises an oxygen source gas that is introduced into the reactor at a flow rate ranging from about 1 to about 10000 square cubic centimeters (sccm) or from about 1 to about 1000 sccm. The oxygen source can be introduced for a time that ranges from about 0.1 to about 100 seconds. The catalyst is selected from a Lewis base such as pyridine, piperazine, trimethylamine, tert-butylamine, diethylamine, trimethylamine, ethylenediamine, ammonia, or other organic amines.

The precursor pulse can have a pulse duration that is greater than 0.01 seconds, and the nitrogen or oxygen source can have a pulse duration that is less than 0.01 seconds, while the water pulse duration can have a pulse duration that is less than 0.01 seconds.

In certain embodiments, the nitrogen or oxygen source is continuously flowing into the reactor while precursor pulse and plasma are introduced in sequence. The precursor pulse can have a pulse duration greater than 0.01 seconds while the plasma duration can range between 0.01 seconds to 100 seconds.

In certain embodiments, the film(s) comprise silicon, nitrogen, and boron. In these embodiments, the films deposited using the methods described herein are formed in the presence of nitrogen-containing source. A nitrogen-containing source may be introduced into the reactor in the form of at least one nitrogen source and/or may be present incidentally in the other precursors used in the deposition process.

Suitable nitrogen-containing or nitrogen source gases may include, for example, ammonia, hydrazine, monoalkylhydrazine, symmetrical or unsymmetrical dialkylhydrazine, organoamines such as methylamine, ethylamine, ethylenediamine, ethanolamine, piperazine, N,N'-dimethylethylenediamine, imidazolidine, cyclotrimethylenetriamine, and combination thereof.

In certain embodiments, the nitrogen source is introduced into the reactor at a flow rate ranging from about 1 to about 10000 square cubic centimeters (sccm) or from about 1 to about 1000 sccm. The nitrogen source can be introduced for a time that ranges from about 0.1 to about 100 seconds. In embodiments wherein the film is deposited by an ALD or a cyclic CVD process using both a nitrogen and oxygen source, the precursor pulse can have a pulse duration that is greater than 0.01 seconds, and the nitrogen source can have a pulse duration that is less than 0.01 seconds, while the water pulse duration can have a pulse duration that is less than 0.01 seconds. In yet another embodiment, the purge duration between the pulses that can be as low as 0 seconds or is continuously pulsed without a purge in-between.

The deposition methods disclosed herein may involve one or more purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon, hydrogen (H₂), and combinations thereof. In certain embodiments, a purge gas such as Ar is supplied into the reactor at a flow rate ranging from about 10 to about 10000 sccm for about 0.1 to 1000 seconds, thereby purging the unreacted material and any byproduct that may remain in the reactor.

The respective step of supplying the precursors, oxygen source, the nitrogen-containing source, and/or other precursors, source gases, and/or reagents may be performed by changing the time for supplying them to change the stoichiometric composition of the resulting film.

Energy is applied to the at least one of the precursor, nitrogen source or nitrogen-containing source, oxygen source, reducing agent, other precursors or combination thereof to induce reaction and to form the film or coating on the substrate. Such energy can be provided by, but not limited to, thermal, plasma, pulsed plasma, helicon plasma, high density plasma, inductively coupled plasma, X-ray, e-beam, photon, remote plasma methods, and combinations thereof.

In certain embodiments, a secondary RF frequency source can be used to modify the plasma characteristics at the substrate surface. In embodiments wherein the deposition involves plasma, the plasma-generated process may comprise a direct plasma-generated process in which plasma is directly generated in the reactor, or alternatively a remote plasma-generated process in which plasma is generated outside of the reactor and supplied into the reactor.

The silicon precursors and/or other silicon- and boron-containing precursors may be delivered to the reaction chamber, such as a CVD or ALD reactor, in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. In liquid delivery formulations, the precursors described herein may be delivered in neat liquid form, or alternatively, may be employed in solvent formulations or compositions comprising same. Thus, in certain embodiments the precursor formulations may include solvent component(s) of suitable character as may be desirable and advantageous in a given end use application to form a film on a substrate.

In this or other embodiments, it is understood that the steps of the methods described herein may be performed in a variety of orders, may be performed sequentially or concurrently (e.g., during at least a portion of another step), and any combination thereof. The respective step of supplying the precursors and the nitrogen-containing source gases may be performed by varying the duration of the time for supplying them to change the stoichiometric composition of the resulting silicon- and boron-containing film.

In a still further embodiment of the method described herein, the film or the as-deposited film is subjected to a treatment step. The treatment step can be conducted during at least a portion of the deposition step, after the deposition step, and combinations thereof. Exemplary treatment steps include, without limitation, treatment via high temperature thermal annealing; plasma treatment; ultraviolet (UV) light treatment; laser; electron beam treatment and combinations thereof to affect one or more properties of the film. The films deposited with the silicon precursors having one or two Si-C-B linkages described herein, when compared to films deposited with previously disclosed silicon precursors under the same conditions, have improved properties such as, without limitation, a wet etch rate that is lower than the wet etch rate of the film before the treatment step or a density that is higher than the density prior to the treatment step. In one particular embodiment, during the deposition process, as-deposited films are intermittently treated. These intermittent or mid-deposition treatments can be performed, for example, after each ALD cycle, after a certain number of ALD, such as, without limitation, one (1) ALD cycle, two (2) ALD cycles, five (5) ALD cycles, or after every ten (10) or more ALD cycles.

In an embodiment wherein the film is treated with a high temperature annealing step, the annealing temperature is at least 100°C or greater than the deposition temperature. In this or other embodiments, the annealing temperature ranges from about 400°C to about 1000°C. In this or other embodiments, the annealing treatment can be conducted in a vacuum (< 760 Torr), inert environment or in oxygen containing environment (such as H₂O, N₂O, NO₂ or O₂)

In an embodiment wherein the film is treated to UV treatment, film is exposed to broad band UV or, alternatively, an UV source having a wavelength ranging from about 150 nanometers (nm) to about 400 nm. In one particular embodiment, the as-deposited film is exposed to UV in a different chamber than the deposition chamber after a desired film thickness is reached.

In an embodiment where in the film is treated with a plasma, passivation layer such as SiO₂ or carbon doped SiO₂ is deposited to prevent chlorine and nitrogen contamination from penetrating film in the subsequent plasma treatment. The passivation layer can be deposited using atomic layer deposition or cyclic chemical vapor deposition.

In an embodiment wherein the film is treated with a plasma, the plasma source is selected from the group consisting of hydrogen plasma, plasma comprising hydrogen and helium, plasma comprising hydrogen and argon. Hydrogen plasma lowers film dielectric constant and boost the damage resistance to following plasma ashing process while still keeping the boron content in the bulk almost unchanged.

Throughout the description, the term "ALD or ALD-like" refers to a process including, but not limited to, the following processes: a) each reactant including precursor and reactive gas is introduced sequentially into a reactor such as a single wafer ALD reactor, semi-batch ALD reactor, or batch furnace ALD reactor; b) each reactant including precursor and reactive gas is exposed to a substrate by moving or rotating the substrate to different sections of the reactor and each section is separated by inert gas curtain, i.e. spatial ALD reactor or roll to roll ALD reactor.

Throughout the description, the term "ashing" refers to a process to remove the photoresist or carbon hard mask in semiconductor manufacturing process using a plasma comprising oxygen source such as O₂/inert gas plasma, O₂ plasma, CO₂ plasma, CO plasma, H₂/O₂ plasma or combination thereof.

Throughout the description, the term "damage resistance" refers to film properties after oxygen ashing process. Good or high damage resistance is defined as the following film properties after oxygen ashing: film dielectric constant lower than 4.5; boron content in the bulk (at more than 50 Å deep into film) is within 5 at. % as before ashing; Less than 50 Å of the film is damaged, observed by differences in dilute HF etch rate between films near surface (less than 50 Å deep) and bulk (more than 50 Å deep).

Throughout the description, the term "alkyl hydrocarbon" refers a linear or branched C₁ to C₂₀ hydrocarbon, cyclic C₆ to C₂₀ hydrocarbon. Exemplary hydrocarbon includes, but not limited to, heptane, octane, nonane, decane, dodecane, cyclooctane, cyclononane, cyclodecane.

Throughout the description, the term "aromatic hydrocarbon" refers a C₆ to C₂₀ aromatic hydrocarbon. Exemplary aromatic hydrocarbon n includes, but not limited to, toluene, mesitylene.

Throughout the description, the term "catalyst" refers a Lewis base in vapor phase which can catalyze surface reaction between hydroxyl group and Si-Cl bond during thermal ALD process. Exemplary catalysts include, but not limited to, at least one of a cyclic amine-based gas such as aminopyridine, picoline, lutidine, piperazine, piperidine, pyridine or an organic amine-based gas methylamine, dimethylamine, trimethylamine, ethylamine, diethylamine, triethylamine, propylamine, iso-propylamine, di-propylamine, di-iso-propylamine, tert-butylamine.

Throughout the description, the term "organic amines" refers a primary amine, secondary amine, tertiary amine having C₁ to C₂₀ hydrocarbon, cyclic C₆ to C₂₀ hydrocarbon. Exemplary organic amines include, but not limited to, methylamine, dimethylamine, trimethylamine, ethylamine, diethylamine, triethylamine, propylamine, iso-propylamine, di-propylamine, di-iso-propylamine, tert-butylamine.

Throughout the description, the term "siloxanes" refer a linear, branched, or cyclic liquid compound having at least one Si-O-Si linkages and C₄ to C₂₀ carbon atoms. Exemplary siloxanes includes, but not limited to, tetramethyldisiloxane, hexamethyldisiloxane (HMDSO), 1,1,1,3,3,5,5,5-octamethyltrisiloxane, octamethylcyclotetrasiloxane (OMCTS).

Throughout the description, the term "step coverage" as used herein is defined as a percentage of two thicknesses of the deposited film in a structured or featured substrate having either vias or trenches or both, with bottom step coverage being the ratio (in %): thickness at the bottom of the feature is divided by thickness at the top of the feature, and middle step coverage being the ratio (in %): thickness on a sidewall of the feature is divided by thickness at the top of the feature. Films deposited using the method described herein exhibit a step coverage of about 80% or greater, or about 90% or greater which indicates that the films are conformal.

Throughout the description, the term "inert gas(es)" refers a non-reactive gas(es) selected from the group consisting of nitrogen, helium, argon, neon, and their combination thereof. The inert gas(es) can be employed to deliver the silicon precursor, to purge the reactor, or maintain the reactor's chamber pressure.

Throughout the description, the term "film(s) comprising silicon and boron" refers to film(s) selected from the group consisting of a silicon borocarboxide, a silicon borocarbonitride, a silicon boroxide, and a silicon borocarboxynitride. The silicon boroxide refers to a film having > 1 at. % of silicon, > 1 at. % of boron and > 1 at. % oxygen while other elements are less than 1 at. %. The silicon borocarboxide refers to a film having > 1 at. % of silicon, > 1 at. % of boron, > 1 at. % of carbon and > 1 at. % oxygen while other elements are less than 1 at. %. The silicon borocarbonitride is a film having > 1 at. % of silicon, > 1 at. % of boron, > 1 at. % of carbon and > 1 at. % nitrogen while other elements are less than1 at. %. The silicon borocarboxynitride refers a film having > 1 at. % of silicon, > 1 at. % of boron, > 1 at. % of carbon, >1 at. % oxygen and > 1 at. % nitrogen while other elements are less than1 at. %.

The following examples illustrate certain aspects of the instant invention and do not limit the scope of the appended claims.

### EXAMPLES

### General Film Deposition

Film depositions were performed in a screening atomic layer deposition (ALD) reactor using a precursor and ammonia as nitrogen source ammonia. The ALD cycle steps and process conditions are provided in the following Table 2.

**Table 2 ALD Cycle Steps and Process Conditions**

| Steps | Descriptions | Time | Notes |
|---|---|---|---|
| 1 | Insert Si substrates into a reactor | | |
| 2 | Heat substrates to desired temperature | ~1-2 hours | T = 300 °C and 600°C |
| 3 | Close throttle valve | 2 seconds (s) | Throttle valve is closed to increase residence time |
| 4 | Deliver precursor dose | 2 s | Vapor draw; Chamber pressure was 0.2-0.3 Torr |
| 5 | Wait | 10 s | Soak precursor in the reactor with no gas in or out |
| 6 | Deliver precursor dose | 2 s | |
| 7 | Wait | 10 s | Soak precursor in the reactor with no gas in or out |
| 8 | Deliver precursor dose | 2 s | |
| 9 | Wait | 10 s | Soak precursor in the reactor with no gas in or out |
| 10 | Open throttle valve | 2 s | |
| 11 | Flow N₂ to purge the reactor | 6 s | N₂ flow is 5 lpm |
| 12 | Evacuate the reactor to base pressure | 6 s | Base pressure is <1 mTorr |
| 13 | Flow NH₃ | 24 s | Pressure is set to 5 Torr; NH₃ flow is 100 sccm |
| 14 | Flow N₂ to purge the reactor | 6 s | N₂ flow is 5 lpm |
| 15 | Evacuate the reactor to base pressure | 6 s | Base pressure is <1 mTorr |
| 16 | Remove Si sample from the reactor | | |

During the deposition, steps 3 to 14 are repeated for a number of cycles of up to 2000 times to get a desired thickness of the carbon containing films. Refractive index and thickness were measured directly after deposition using an ellipsometer at 632.8 nm. Bulk film composition was characterized using X-Ray Photoelectron Spectroscopy (XPS) at few nanometer (~5 nm) down from the surface inorder to eliminate effect of adventitious carbon.

Oxygen ash was performed in commercial asher (PVA Tepla Metroline 4L). Process parameters were as follows: 100 sccm helium, 300 sccm oxygen, 600 torr pressure, plasma power was set to 200 W. The ashing was performed at room temperature. The depth of damage was measured using dilute HF etch.

Wet etch rate process was performed under two different concentrations of dilute hydrofluoric acid (dHF) with concentration of 1:99 ratio of 49% HF to DI water. During the process, a thermal silicon oxide film was etched at the same time used to ensure etch solution consistency.

Dielectric constant (k) and leakage current were measured by depositing metal electrode on the films to form metal-insulator-semiconductor capacitor (MISCAP) structure. The leakage current density was reported at 1 MV/cm bias voltage.

Working Example 1: The film comprising silicon and boron deposited using 1-(trichlorosilyl)-1-(dichloroboryl)ethane and ammonia

The film comprising silicon and boron was deposited using 1-(trichlorosilyl)-1-(dichloroboryl)ethane and ammonia in ALD screening reactor at 300°C to 600°C. The process parameters and ALD cycles are listed on Table 2. Total precursor exposure was 2-3 Torr.s while total NH₃ exposure was 125 Torr.s. Films were exposed to trace moisture in ambient after deposition for at least 24 hours prior to the metrology measurements.

**Table 3. Film properties of film deposited from 1-(trichlorosilyl)-1-(dichloroboryl)ethane and ammonia**

| Substrate Temperature (°C) | GPC (A/cycle) | XPS B (at.%) | XPS C (at.%) | XPS Cl (at.%) | XPS N (at.%) | XPS O (at.%) | XPS Si (at.%) |
|---|---|---|---|---|---|---|---|
| 300 | 0.5 | 20.2 | 19.6 | 0.9 | 6.3 | 34.4 | 18.5 |
| 400 | 0.5 | 21.7 | 19.5 | 0.9 | 6.1 | 32.1 | 19.84 |
| 500 | 0.9 | 32.6 | 14.7 | 0.9 | 26.7 | 9.2 | 15.9 |
| 600 | 1.1 | 39.0 | 9.7 | ND | 35.3 | 3.5 | 12.5 |

Oxygen that was present in the films was believed to be from a post-deposition air exposure This demonstrated proof of concept of film composition tunability by exposing films to oxidation agent to convert silicon boronitride into silicon boronoxynitride.

Film deposited at 600 °C has k value of 4.1 and leakage current density of 9E-8 A/cm² The film dilute HF etch rate is 60% lower than that of thermal silicon oxide.

Film deposited at 600 °C, as demonstrated in the Working Example 1, was deposited on a patterned structure with an aspect ratio of 1.9. The structure opening was 130 nm. Cross section TEM was used to analyze the film thickness at different locations of the trench. As shown in Table 4, the film shows conformality of > 97%.

**Table 4. Film thickness at different locations in the trench**

| Location of measurement | Film thickness (nm) |
|---|---|
| Top | 10.1 |
| Top half | 10.3 |
| Bottom half | 10.4 |
| Bottom | 10.3 |

Working Example 2: Film comprising silicon and boron deposited using a 1-(trichlorosilyl)-1-(dichloroboryl)ethane, ammonia and water vapor

Silicon on boron containing films were deposited using -(trichlorosilyl)-1-(dichloroboryl)ethane, ammonia and water vapor using the steps described in Table 5.

**Table 5. ALD steps and process parameters used in film deposition**

| Steps | Descriptions | Time | Notes |
|---|---|---|---|
| 1 | Insert Si substrates into a reactor | | |
| 2 | Heat substrates to desired temperature | ~1-2 hours | T = 400°C and 600°C |
| 3 | Close throttle valve | 2 seconds (s) | Throttle valve is closed to increase residence time |
| 4 | Deliver precursor dose | 3 s | Vapor draw; Chamber pressure was 0.2 torr |
| 5 | Wait | 5 s | Soak precursor in the reactor with no gas in or out |
| 6 | Deliver precursor dose | 3 s | Vapor draw; Chamber pressure was 0.2 torr |
| 7 | Wait | 5 s | Soak precursor in the reactor with no gas in or out |
| 8 | Deliver precursor dose | 3 s | Vapor draw; Chamber pressure was 0.2 torr |
| 9 | Wait | 5 s | Soak precursor in the reactor with no gas in or out |
| 10 | Open throttle valve | 2 s | |
| 11 | Flow N₂ to purge the reactor | 30 s | N₂ flow is 1 lpm |
| 12 | Flow NH₃ | 24 s | Pressure is set to 5 Torr; NH₃ flow is 100 sccm |
| 13 | Flow N₂ to purge the reactor | 30 s | N₂ flow is 5 lpm |
| 14 | Flow H2O vapor | 30 s | Vapor draw; Chamber pressure is set to 5 Torr; |
| 15 | Flow N₂ to purge the reactor | 6 s | N₂ flow is 5 lpm |
| 16 | Evacuate the reactor to base pressure | 6 s | Base pressure is <1 mTorr |
| 17 | Remove Si sample from the reactor | | |

Steps 3 to 16 were repeated multiple times to get a desired film thickness.

**Table 6. Properties of film deposited from 1-(trichlorosilyl)-1-(dichloroboryl)ethane, ammonia, and water vapor**

| Substrate Temperature (°C) | GPC (A/cycle) | XPS B (at.%) | XPS C (at.%) | XPS Cl (at.%) | XPS N (at.%) | XPS O (at.%) | XPS Si (at.%) |
|---|---|---|---|---|---|---|---|
| 400 | 1.4 | 16.8 | 21.6 | ND | 2.5 | 40.9 | 18.2 |
| 600 | 1.0 | 36.1 | 6.5 | ND | 29.1 | 18.0 | 10.4 |

Table 6 summarizes the deposited films GPC and film composition. Film composition can be tuned by changing the deposition temperatures as well as co-reactants.

Working Example 3: Film comprising silicon and boron deposited using a (trichlorosilyl)(dichloroboryl)methane and ammonia

Silicon and boron containing films were deposited using (trichlorosilyl)(dichloroboryl)methane and ammonia by following the steps outlined in Table 7.

**Table 7. ALD steps and process parameters used in film deposition**

| Steps | Descriptions | Time | Notes |
|---|---|---|---|
| 1 | Insert Si substrates into a reactor | | |
| 2 | Heat substrates to desired temperature | ~1-2 hours | T = 400°C and 600°C |
| 3 | Close throttle valve | 2 seconds (s) | Throttle valve is closed to increase residence time |
| 4 | Deliver precursor dose | 3 s | Vapor draw; Chamber pressure was 0.2 torr |
| 5 | Wait | 5 s | Soak precursor in the reactor with no gas in or out |
| 6 | Deliver precursor dose | 3 s | Vapor draw; Chamber pressure was 0.2 torr |
| 7 | Wait | 5 s | Soak precursor in the reactor with no gas in or out |
| 8 | Deliver precursor dose | 3 s | Vapor draw; Chamber pressure was 0.2 torr |
| 9 | Wait | 5 s | Soak precursor in the reactor with no gas in or out |
| 10 | Open throttle valve | 2 s | |
| 11 | Flow N₂ to purge the reactor | 30 s | N₂ flow is 1 lpm |
| 12 | Flow NH₃ | 24 s | Pressure is set to 5 Torr; NH₃ flow is 100 sccm |
| 13 | Flow N₂ to purge the reactor | 30 s | N₂ flow is 5 lpm |
| 14 | Evacuate the reactor to base pressure | 6 s | Base pressure is <1 mTorr |
| 15 | Remove Si sample from the reactor | | |

Steps 3 to 13 were repeated multiple times to get a desired film thickness.

**Table 8. Film properties of films deposited from (trichlorosilyl)(dichloroboryl)methane and ammonia**

| Substrate Temperature (°C) | GPC (A/cycle) | XPS B (at.%) | XPS C (at.%) | XPS Cl (at.%) | XPS N (at.%) | XPS O (at.%) | XPS Si (at.%) |
|---|---|---|---|---|---|---|---|
| 400 | 0.9 | 17.9 | 13.4 | ND | 2.0 | 47.5 | 19.2 |
| 600 | 0.8 | 21.6 | 9.8 | ND | 28.3 | 19.7 | 20.6 |

Table 8 summarizes the GPC and film compositions. The film composition is tunable by changing deposition temperatures.

The film deposited at 600 °C has a k value of 4.2 and a leakage current density of 1.0E-8 A/cm² at 1 MV/cm bias voltage. The dilute HF wet etch rate for 600 °C film is 60% lower than that of thermal silicon oxide, demonstrating that the silicon and boron containing film is better than thermal silicon oxide.

Working Example 4: Film comprising silicon and boron deposited using a (trichlorosilyl)(dichloroboryl)methane, ammonia and water vapor

Silicon and boron containing films were deposited using (trichlorosilyl)(dichloroboryl)methane, ammonia and water vapor using the steps described in Table 9.

**Table 9. ALD steps and process parameters used in film deposition**

| Steps | Descriptions | Time | Notes |
|---|---|---|---|
| 1 | Insert Si substrates into a reactor | | |
| 2 | Heat substrates to desired temperature | ~1-2 hours | T = 400°C and 600°C |
| 3 | Close throttle valve | 2 seconds (s) | Throttle valve is closed to increase residence time |
| 4 | Deliver precursor dose | 3 s | Vapor draw; Chamber pressure was 0.2 torr |
| 5 | Wait | 5 s | Soak precursor in the reactor with no gas in or out |
| 6 | Deliver precursor dose | 3 s | Vapor draw; Chamber pressure was 0.2 torr |
| 7 | Wait | 5 s | Soak precursor in the reactor with no gas in or out |
| 8 | Deliver precursor dose | 3 s | Vapor draw; Chamber pressure was 0.2 torr |
| 9 | Wait | 5 s | Soak precursor in the reactor with no gas in or out |
| 10 | Open throttle valve | 2 s | |
| 11 | Flow N₂ to purge the reactor | 30 s | N₂ flow is 1 lpm |
| 12 | Flow NH₃ | 24 s | Pressure is set to 5 Torr; NH₃ flow is 100 sccm |
| 13 | Flow N₂ to purge the reactor | 30 s | N₂ flow is 5 lpm |
| 14 | Flow H2O vapor | 30 s | Vapor draw; Chamber pressure is set to 5 Torr; |
| 15 | Flow N₂ to purge the reactor | 6 s | N₂ flow is 5 lpm |
| 16 | Evacuate the reactor to base pressure | 6 s | Base pressure is <1 mTorr |
| 17 | Remove Si sample from the reactor | | |

Step 3 to Step 16 were repeated multiple times to get desired a film thickness.

**Table 10. Film properties of film deposited from (trichlorosilyl)(dichloroboryl)methane, ammonia and water vapor**

| Substrate Temperature (°C) | GPC (A/cycle) | XPS B (at.%) | XPS C (at.%) | XPS Cl (at.%) | XPS N (at.%) | XPS O (at.%) | XPS Si (at.%) |
|---|---|---|---|---|---|---|---|
| 400 | 0.5 | 18.0 | 13.5 | ND | 1.8 | 47.4 | 19.3 |
| 600 | 0.5 | 18.2 | 9.0 | ND | 19.0 | 32.1 | 21.7 |

Table 10 summarizes GPC and film compositions. The film composition is tunable by changing process deposition temperature.

The film deposited at 600 °C has k value of 4.5 and a leakage current density of 1.0E-8 A/cm² at 1 MV/cm bias voltage. The dilute HF etch rate for the film deposited at 600 °C is 30% lower than that of thermal silicon oxide.

## Claims

1. A composition for ALD deposition of film comprising silicon and boron comprises:
(a) 2-(trichlorosilyl)-2-(dichloroboryl)propane and
(b) at least one solvent.

2. Use of a composition comprising:
(a) at least one precursor compound having one Si-C-B linkage selected from the group consisting of trichlorosilyl(dichloroboryl)methane, 1-(trichlorosilyl)-1-(dichloroboryl)ethane, 2-(trichlorosilyl)-2-(dichloroboryl)propane, and (dichloromethylsilyl)(dichloroboryl)methane; and
(b) at least one solvent
for the ALD deposition of a film comprising silicon and boron.

3. The composition of claim 1 or the use of claim 2 wherein the solvent comprises at least one member selected from the group consisting of ether, tertiary amine, siloxanes, alkyl hydrocarbon, aromatic hydrocarbon, and tertiary aminoether.

4. The composition of claim 1 or the use of claim 2 wherein the difference between the boiling point of the at least one precursor and the boiling point of the at least one solvent is 40°C or less.

5. The composition of claim 1 or the use of claim 2 further comprising less than 5 ppm of at least one metal ion selected from the group consisting of Al, Li, Ca, Fe, Ni, and Cr ions as measured by ICP-MS.

6. The composition of claim 1 or the use of claim 2 wherein the at least one solvent comprises at least one member selected from the group consisting of heptane, octane, nonane, decane, dodecane, cyclooctane, cyclononane, cyclodecane, toluene, and mesitylene.

7. A stainless steel container housing and containing the composition of claim 1.

8. A method for forming a film comprising silicon and boron with a boron content ranging from 10 at. % to 40 at. % as measured by XPS via an ALD process, the method comprising:
a) placing one or more substrates comprising a surface feature into an ALD reactor;
b) heating the reactor to one or more temperatures ranging from ambient temperature to 700°C, and optionally maintaining the reactor at a pressure of 100 torr or less;
c) introducing into the reactor at least one precursor having a Si-C-B linkage;
d) purging the reactor using an inert gas;
e) providing a nitrogen or oxygen source into the reactor to react with at least the at least one precursor and thereby form the film comprising silicon and boron;
f) purging the reactor with inert gas;
g) repeating steps c to f to provide a desired thickness of the film comprising silicon and boron;
h) optionally treating the film comprising silicon and boron with an oxygen source at one or more temperatures ranging from ambient temperature to 1000°C, or from 100° to 400°C, to convert the film comprising silicon and boron into a silicon borocarboxynitride or a silicon boroxynitride film; and
i) optionally exposing the film comprising silicon and boron to a plasma comprising hydrogen;
wherein the at least one precursor is selected from the group consisting of trichlorosilyl)(dichloroboryl)methane, 1-(trichlorosilyl)-1-(dichloroboryl)ethane, 2-(trichlorosilyl)-2-(dichloroboryl)propane, and (dichloromethylsilyl)(dichloroboryl)methane.

## Patentansprüche

1. Eine Zusammensetzung für die ALD-Abscheidung eines Films, der Silizium und Bor umfasst, umfassend:
(a) 2-(Trichlorsilyl)-2-(dichlorboryl)propan und
(b) mindestens ein Lösungsmittel.

2. Verwendung einer Zusammensetzung, umfassend:
(a) mindestens eine Vorläuferverbindung mit einer Si-C-B-Bindung, ausgewählt aus der Gruppe bestehend aus Trichlorsilyl(dichloroboryl)methan, 1-(Trichlorsilyl)-1-(dichloroboryl)ethan, 2-(Trichlorsilyl)-2-(dichlorboryl)propan und (Dichlormethylsilyl)(dichlorboryl)methan; und
(b) mindestens ein Lösungsmittel
zur ALD-Abscheidung eines Films, der Silizium und Bor umfasst.

3. Die Zusammensetzung nach Anspruch 1 oder die Verwendung nach Anspruch 2, wobei das Lösungsmittel mindestens einen Vertreter aus der Gruppe bestehend aus Ether, tertiärem Amin, Siloxanen, Alkylkohlenwasserstoff, aromatischem Kohlenwasserstoff und tertiärem Aminoether umfasst.

4. Die Zusammensetzung nach Anspruch 1 oder die Verwendung nach Anspruch 2, wobei die Differenz zwischen dem Siedepunkt des mindestens einen Vorläufers und dem Siedepunkt des mindestens einen Lösungsmittels 40°C oder weniger beträgt.

5. Die Zusammensetzung nach Anspruch 1 oder die Verwendung nach Anspruch 2, die ferner weniger als 5 ppm mindestens eines Metallions enthält, das aus der Gruppe ausgewählt ist, die aus Al, Li, Ca, Fe, Ni und Cr-Ionen besteht, gemessen mittels ICP-MS.

6. Die Zusammensetzung nach Anspruch 1 oder die Verwendung nach Anspruch 2, wobei das mindestens eine Lösungsmittel mindestens ein Mitglied umfasst, das aus der Gruppe ausgewählt ist, die aus Heptan, Oktan, Nonan, Decan, Dodecan, Cyclooctan, Cyclononan, Cyclodecan, Toluol und Mesitylen besteht.

7. Ein Edelstahlbehälter, der die Zusammensetzung nach Anspruch 1 aufnimmt und enthält.

8. Verfahren zur Herstellung eines Films, der Silizium und Bor umfasst, mit einem Borgehalt im Bereich von 10 at. % bis 40 at. %, gemessen mittels XPS, mittels eines ALD-Verfahrens, das Verfahren umfassend:
a) Einbringen eines oder mehrerer Substrate, die eine Oberflächenstruktur aufweisen, in einen ALD-Reaktor;
b) Erhitzen des Reaktors auf eine oder mehrere Temperaturen im Bereich von Raumtemperatur bis 700 °C und gegebenenfalls Halten des Reaktors bei einem Druck von 100 Torr oder weniger;
c) Einleiten mindestens eines Vorläufers mit einer Si-C-B-Bindung in den Reaktor;
d) Spülen des Reaktors mit einem Inertgas;
e) Einleiten einer Stickstoff- oder Sauerstoffquelle in den Reaktor, um mit dem mindestens einen Vorläufer zu reagieren und dadurch den Films, der Silizium und Bor umfasst, zu bilden;
f) Spülen des Reaktors mit Inertgas;
g) Wiederholen der Schritte c bis f, um eine gewünschte Dicke des Films, der Silizium und Bor umfasst, zu erzielen;
h) optionalen Behandeln des Films, der Silizium und Bor umfasst, mit einer Sauerstoffquelle bei einer oder mehreren Temperaturen im Bereich von Umgebungstemperatur bis 1000 °C oder von 100 °C bis 400 °C, um den Film, der Silizium und Bor umfasst, in einen Siliziumborocarboxynitrid- oder einen Siliziumboroxynitrid-Film umzuwandeln; und
i) optional das Aussetzen des Films, der Silizium und Bor umfasst, einem Plasma, das Wasserstoff enthält;
wobei der mindestens eine Vorläufer aus der Gruppe ausgewählt ist, die aus Trichlorsilyl(dichlorboryl)methan, 1-(Trichlorsilyl)-1-(dichlorboryl)ethan, 2-(Trichlorsilyl)-2-(dichlorboryl)propan und (Dichlormethylsilyl)(dichlorboryl)methan.

## Revendications

1. Composition pour le dépôt ALD d'un film comprenant du silicium et du bore comprenant :
(a) du 2-(trichlorosilyl)-2-(dichloroboryl)propane et
(b) au moins un solvant.

2. Utilisation d'une composition comprenant :
(a) au moins un composé précurseur ayant une liaison Si-C-B choisi dans le groupe constitué par trichlorosilyl(dichloroboryl)méthane, 1-(trichlorosilyl)-1-(dichloroboryl)éthane, 2-(trichlorosilyl)-2-(dichloroboryl)propane et (dichlorométhylsilyl)(dichloroboryl)méthane ; et
(b) au moins un solvant
pour le dépôt ALD d'un film comprenant du silicium et du bore.

3. Composition selon la revendication 1 ou utilisation selon la revendication 2, dans laquelle le solvant comprend au moins l'un choisi dans le groupe constitué par un éther, une amine tertiaire, des siloxanes, un hydrocarbure de type alkyle, un hydrocarbure aromatique, et un aminoéther tertiaire.

4. Composition selon la revendication 1 ou utilisation selon la revendication 2, dans laquelle la différence entre le point d'ébullition de l'au moins un précurseur et le point d'ébullition de l'au moins un solvant est de 40 °C ou moins.

5. Composition selon la revendication 1 ou utilisation selon la revendication 2, comprenant en outre moins de 5 ppm d'au moins un ion métallique choisi dans le groupe constitué par des ions Al, Li, Ca, Fe, Ni et Cr tel que mesuré par ICP-MS.

6. Composition selon la revendication 1 ou utilisation selon la revendication 2, dans laquelle l'au moins un solvant comprend au moins un élément choisi dans le groupe constitué par l'heptane, l'octane, le nonane, le décane, le dodécane, le cyclooctane, le cyclononane, le cyclodécane, le toluène, et le mésitylène.

7. Récipient en acier inoxydable logeant et contenant la composition de la revendication 1.

8. Procédé pour former un film comprenant du silicium et du bore ayant une teneur en bore allant de 10 % at. à 40 % at. telle que mesurée par XPS via un procédé ALD, le procédé comprenant :
a) placement d'un ou plusieurs substrats comprenant une caractéristique de surface dans un réacteur d'ALD ;
b) chauffage du réacteur jusqu'à une ou plusieurs températures dans la plage de la température ambiante à 700 °C, et facultativement maintien du réacteur à une pression de 100 torr ou moins ;
c) introduction dans le réacteur d'au moins un précurseur possédant une liaison Si-C-B ;
d) purge du réacteur à l'aide d'un gaz inerte ;
e) fourniture d'une source d'azote ou d'oxygène dans le réacteur pour réagir avec au moins l'au moins un précurseur et former ainsi le film comprenant du silicium et du bore ;
f) purge du réacteur à l'aide d'un gaz inerte ;
g) répétition des étapes c à f pour fournir une épaisseur souhaitée du film comprenant du silicium et du bore ;
h) éventuellement traitement du film comprenant du silicium et du bore par une source d'oxygène à une ou plusieurs températures allant de la température ambiante à 1 000 °C, ou de 100 ° à 400 °C, pour convertir le film comprenant du silicium et du bore en un film de borocarboxynitrure de silicium ou de boroxynitrure de silicium ; et
i) facultativement exposition du film comprenant du silicium et du bore à un plasma comprenant de l'hydrogène;
dans lequel l'au moins un précurseur est choisi dans le groupe constitué par trichlorosilyl)(dichloroboryl)méthane, 1-(trichlorosilyl)-1-(dichloroboryl)éthane, 2-(trichlorosilyl)-2-(dichloroboryl)propane et (dichlorométhylsilyl)(dichloroboryl)méthane.
